# EUROPEAN PATENT SPECIFICATION

(11) **EP 4 020 545 B1**
(45) Date of publication and mention of the grant of the patent: **10.04.2024**
(21) Application number: 20869683.1
(22) Date of filing: 24.09.2020
(51) Int. Cl.: H01L 23/36, H01L 23/373, C08L 83/04, C08L 101/00, C08K 3/013, C08K 3/38, H05K 7/20, H01L 23/42, C08K 7/14

(54) **HEAT DISSIPATION SHEET**
WÄRMEABLEITUNGSFOLIE
FEUILLE DE DISSIPATION DE CHALEUR

(30) Priority: 26.09.2019 JP 2019175067
(43) Date of publication of application: 29.06.2022
(73) Proprietor: Denka Company Limited, Tokyo 103-8338 (JP)
(72) Inventor: WADA, Kosuke, Tokyo 103-8338 (JP); KANEKO, Masahide, Tokyo 103-8338 (JP); NONOGAKI, Ryozo, Tokyo 103-8338 (JP)
(74) Representative: Gulde & Partner
(86) International application number: PCT/JP2020/035911
(87) International publication number: WO 2021/060321

(56) References cited:
- WO-A1-2018/061447
- JP-A- 2007 302 822
- JP-A- 2008 274 119
- JP-A- 2009 013 340

## Description

### Technical Field

The present invention relates to a heat-radiating sheet.

### Background Art

Heat-generating electronic components, such as power devices, transistors, thyristors, and CPUs, generate a large quantity of heat at the time of use, and therefore, it is needed to cool the heat-generating electronic components. But, if an electric power which is consumed in cooling of the heat-generating electronic component is large, the electric power consumption of electronic equipment equipped with a heat-generating electronic component becomes large. Accordingly, how to efficiently cool the heat-generating electronic component is an important issue.

In heat-generating electronic components, how to efficiently radiate heat generated at the time of use is an important issue. As a countermeasure against such heat radiation, in general, the heat radiation has hitherto been performed by conducting the heat generated from the heat-generating electronic component into a heat-radiating component, such as a heat sink. In order to thermally conduct the heat generated from the heat-generating electronic component with efficiency into the heat-radiating component, it is desired to fill an air gap at a contact interface between the heat-generating electronic component and the heat-radiating component with a heat-radiating material. Heat-radiating sheets have hitherto been used as such a heat-radiating material because of easy handling (see, for example, JP 2012-39060 A).

### Summary of Invention

### Technical Problem

Among electronic products, there are ones which are used in the environment to be exposed to gasoline or engine oil. For an electronic component in such an environment, if a heat-radiating sheet can be used for radiating the heat generated from the electronic component, such is useful. Accordingly, a heat-radiating sheet having high tolerance against gasoline and engine oil is demanded.

Then, an object of the present invention is to provide a heat-radiating sheet having high tolerance against gasoline and engine oil.

### Solution to Problem

In order to achieve the aforementioned object, the present inventors made extensive and intensive investigations. As a result, it has been found that the aforementioned object can be achieved by using a heat-radiating sheet having a volume resistivity of more than a specified value nevertheless impregnated with an antifreeze containing 98% by mass or more of ethylene glycol at a temperature of 25°C for 250 hours.

The present invention is based on the aforementioned findings, and a gist thereof is as follows.
[1] Aheat-radiating sheet having a volume resistivity of 1.0 × 10⁹ Ω·cm or more, the volume resistivity being measured by a method comprising impregnating the heat-radiating sheet with an antifreeze containing 98% by mass or more of ethylene glycol at a temperature 25°C for 250 hours and subsequently applying a direct current voltage of 500 V according to JIS K6911-1995.
[2] The heat-radiating sheet as set forth above in [1], wherein a withstanding voltage of the heat-radiating sheet is 6.0 kV or more, the withstanding voltage being measured by allowing the heat-radiating sheet to intervene between a TO-3P type transistor and an aluminum plate, fixing the TO-3P type transistor to the aluminum plate at a tightening torque of 12 kgf·cm by using a screw, and impressing an alternating current voltage having a frequency of 60 Hz between a drain of the TO-3P type transistor and the aluminum plate.
[3] The heat-radiating sheet as set forth above in [1] or [2], containing a resin binder and an inorganic filler.
[4] The heat-radiating sheet as set forth above in [3], wherein the resin binder is a silicone resin.
[5] The heat-radiating sheet as set forth above in [3] or [4], wherein the inorganic filler is a coagulated particle of hexagonal boron nitride.
[6] The heat-radiating sheet as set forth above in any one of [3] to [5], containing a glass cloth.
[7] The heat-radiating sheet as set forth above in any one of [1] to [6], containing a base material resin layer including a resin having a glass transition point of 200°C or higher.

### Advantageous Effects of Invention

In accordance with the present invention, it is possible to provide a heat-radiating sheet having high tolerance against gasoline and engine oil.

### Brief Description of Drawing

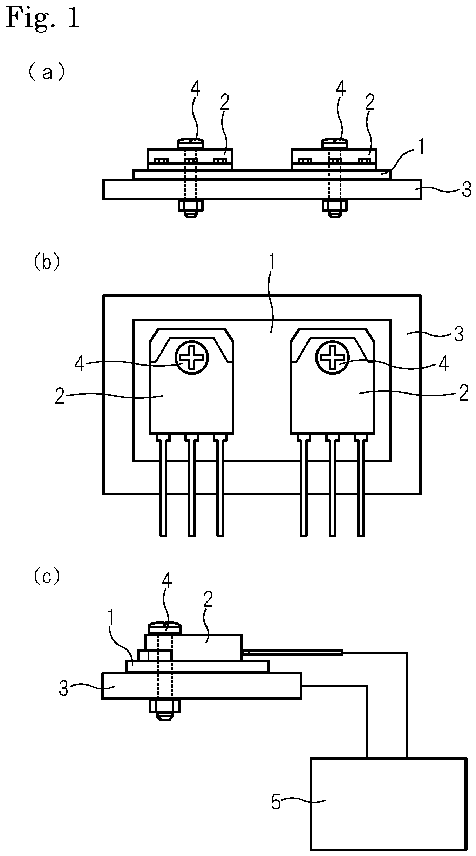

"Fig. 1": Fig. 1(a) to Fig. 1(c) are each a view for explaining a measurement method of the withstanding voltage of a heat-radiating sheet.

### Description of Embodiment

The heat-radiating sheet of the present invention is hereunder described.

### [Volume Resistivity of Heat-Radiating Sheet]

The heat-radiating sheet of the present invention is a heat-radiating sheet having a volume resistivity of 1.0 × 10⁹ Ω·cm or more as measured by a direct current voltage of 500 V according to JIS K6911 after being impregnated with an antifreeze containing 98% by mass or more of ethylene glycol at a temperature 25°C for 250 hours. When the aforementioned volume resistivity is less than 1.0 × 10⁹ Ω·cm, when used upon being exposed to gasoline or engine oil, there is a case where deterioration of the heat-radiating sheet becomes remarkable. From such viewpoint, the aforementioned volume resistivity in the heat-radiating sheet of the present invention is preferably 5.0 × 10⁹ Ω·cm or more, more preferably 1.0 × 10¹⁰ Ω·cm or more, still more preferably 1.0 × 10¹¹ Ω·cm or more, and yet still more preferably 5.0 × 10¹¹ Ω·cm or more. Although an upper limit value of the aforementioned volume resistivity is not particularly limited, it is, for example, 1.0 × 10¹⁷ Ω•cm.

In addition, there is a case where the antifreeze contains, in addition to ethylene glycol, additives, such as an antioxidant and a rust preventive (e.g., a silicate salt, a phosphate salt, an amine, and an oxidizing agent). But, such an additive is contained in a minute amount as compared with ethylene glycol, and therefore, such an additive scarcely affects the volume resistivity of the heat-radiating sheet and a withstanding voltage of the heat-radiating sheet as mentioned later.

It may be considered that the fact that the aforementioned volume resistivity of the heat-radiating sheet of the present invention is 1.0 × 10⁹ Ω·cm or more resides in the following reason. But, it should be construed that the following reason does not limit the present invention.

The heat-radiating sheet of the present invention can be, for example, fabricated by molding a composition for heat-radiating sheet containing a resin and a filler to fabricate a molded body and then heating and pressurizing the molded body at a predetermined curing temperature to undergo curing. Furthermore, as for the heat-radiating sheet of the present invention, before heating and pressurizing the molded body at the aforementioned curing temperature to undergo curing, the molded body is heated and pressurized at a temperature lower than the aforementioned curing temperature. At this stage, since the molded body is not cured, voids in the molded body are collapsed due to pressurization. According to this, it may be considered that permeation of the antifreeze into the voids of the heat-radiating sheet is suppressed, and as a result, swelling of the resin due to the antifreeze is suppressed. Then, it may be considered that the aforementioned volume resistivity of the heat-radiating sheet becomes 1.0 × 10⁹ Ω·cm or more. Since the gasoline and engine oil hardly permeate into the voids of the heat-radiating sheet as compared with the antifreeze, so long as the aforementioned volume resistivity of the heat-radiating sheet due to the antifreeze is 1.0 × 10⁹ Ω·cm or more, the tolerance against gasoline and engine oil is stabilized over a long period of time. As mentioned above, the present invention is concerned with a heat-radiating sheet in which the tolerance against gasoline and engine oil, which is obtained by adjusting properties of the heat-radiating sheet while utilizing the change (change of volume resistivity) of the heat-radiating sheet generated due to the antifreeze, is stabilized over a long period of time.

### [Withstanding Voltage of Heat-Radiating Sheet]

In the case of allowing the heat-radiating sheet to intervene between a TO-3P type transistor and an aluminum plate, fixing the TO-3P type transistor to the aluminum plate at a tightening torque of 12 kgf·cm by using a screw, and impressing an alternating current voltage having a frequency of 60 Hz between a drain of the TO-3P type transistor and the aluminum plate, a withstanding voltage of the heat-radiating sheet of the present invention is preferably 6.0 kV or more. When the withstanding voltage of the heat-radiating sheet of the present invention is 6.0 kV or more, the tolerance against gasoline and engine oil is more improved. From such viewpoint, the aforementioned withstanding voltage of the heat-radiating sheet of the present invention is more preferably 9.0 kV or more, and still more preferably 10.0 kV or more. Although an upper limit value of the aforementioned withstanding voltage of the heat-radiating sheet of the present invention is not particularly limited, it is, for example, 30.0 kV In addition, the aforementioned withstanding voltage can be, for example, measured by a method mentioned in the section of Examples as mentioned later.

### [Thickness of Heat-Radiating Sheet]

A thickness of the heat-radiating sheet of the present invention is preferably 100 to 1,000 pm. When the thickness of the heat-radiating sheet of the present invention is 100 pm or more, the heat-radiating sheet is able to more likely follow unevennesses of the mounting surface of the heat-generating electronic component. On the other hand, when the thickness of the heat-radiating sheet of the present invention is 1,000 pm or less, the thermal resistance of the heat-radiating sheet can be reduced. From such viewpoint, the thickness of the heat-radiating sheet of the present invention is more preferably 150 to 650 pm.

### [Components of Heat-Radiating Sheet]

It is preferred that the heat-radiating sheet of the present invention contains the resin binder and the filler. According to this, it becomes easy to fabricate a heat-radiating sheet in which the aforementioned volume resistivity is 1.0 × 10⁹ Ω·cm or more.

### (Resin Binder)

The resin binder which is used for the heat-radiating sheet of the present invention is not particularly limited so long as it is a resin binder usually used for a heat-radiating sheet. Examples of the resin binder which is used for the heat-radiating sheet of the present invention include epoxy resins, silicone resins, acrylic resins, phenol resins, melamine resins, polyurethane resins, urea resins, unsaturated polyesters, fluorine resins, polyamides (for example, polyimide, polyamide-imide, and polyether imide), polyesters (for example, polybutylene terephthalate and polyethylene terephthalate), polyphenylene ethers, polyphenylene sulfides, wholly aromatic polyesters, polysulfones, liquid crystal polymers, polyether sulfones, polycarbonates, maleimide-modified resins, ABS resins, AAS (acrylonitrile-acrylic rubber/styrene) resins, and AES (acrylonitrile/ethylene/propylene/diene rubber-styrene) resins. These can be used either alone or in combination of two or more thereof. From the viewpoint of facilitating handling of the heat-radiating sheet and the viewpoint of more enhancing adhesion of the heat-radiating sheet owing to flexibility of the heat-radiating sheet, the resin binder is preferably a rubber or an elastomer. Of these resins, silicone resins are preferred from the viewpoint of heat resistance, weather resistance, electric insulation, and chemical stability.

From the viewpoint that ionic impurities as a cause of metal corrosion are not contained and that by-products are not formed after the reaction, the silicone resin which is used for the heat-radiating sheet of the present invention is preferably an addition reaction type silicone resin. The addition reaction type silicone resin is one resulting from curing through a hydrosilylation reaction between an alkenyl group and a hydrogen atom bound to a silicon atom by using a platinum compound as a catalyst. Examples of the addition reaction type silicone resin include silicones of a trade name "LR3303A/B", manufactured by Wacker Asahikasei Silicone Co., Ltd.

### (Filler)

The filler which is used for the heat-radiating sheet of the present invention is not particularly limited so long as it is a filler usually used for a heat-radiating sheet. Examples of the filler which is used for the heat-radiating sheet of the present invention include an inorganic filler and a metal-based filler. Examples of the inorganic filler include zinc oxide, alumina, boron nitride, aluminum nitride, silicon carbide, and silicon nitride. Examples of the metal-based filler include aluminum, silver, and copper. These can be used either alone or in combination of two or more thereof. Of these, from the viewpoint of electric insulation, an inorganic filler is preferred, and a massively coagulated inorganic filler is more preferred. Among these inorganic fillers, boron nitride is more preferred from the viewpoint of thermal conductivity and chemical stability. In addition, since the boron nitride has anisotropy in the thermal conductivity, a massive boron nitride particle in which this anisotropy of thermal conductivity is suppressed is still more preferred. The massive boron nitride particle is a particle resulting from massively coagulating flaky particles of hexagonal boron nitride.

### <Average Particle Diameter of Filler>

An average particle diameter of the filler is preferably 5 to 90 pm. When the average particle diameter of the filler is 5 pm or more, the content of the filler can be made high. On the other hand, when the average particle diameter of the filler is 90 pm or less, the heat-radiating sheet can be made thin. From such viewpoint, the average particle diameter of the filler is more preferably 10 to 70 pm, still more preferably 15 to 50 pm, and especially preferably 15 to 45 pm. The average particle diameter of the filler can be, for example, measured using a laser diffraction scattering particle size analyzer (LS-13 320), manufactured by Beckman-Coulter, Inc. As the average particle diameter of the filler, one measured without applying a homogenizer thereto before the measurement treatment can be adopted. In consequence, in the case where the filler is a coagulated particle, the average particle diameter of the filler is the average particle diameter of the coagulated particles. The obtained average particle diameter is, for example, an average particle diameter in terms of a volume statistics value.

### <Content of Filler>

The content of the filler relative to 100% by volume of the total of the resin binder and the filler is preferably 30 to 85% by volume. In the case where the content of the filler is 30% by volume or more, the thermal conductivity of the heat-radiating sheet is improved, and a sufficient heat-radiating performance is readily obtained. In addition, in the case where the content of the filler is 85% by volume or less, the matter that the voids are liable to be formed at the time of molding the heat-radiating sheet can be suppressed, and the insulation and mechanical strength of the heat-radiating sheet can be enhanced. From such viewpoint, the content of the filler relative to 100% by volume of the total of the resin binder and the filler is more preferably 40 to 80% by volume, and still more preferably 45 to 70% by volume.

### (Reinforcing Layer)

The heat-radiating sheet of the present invention may is provided with a reinforcing layer. The reinforcing layer takes a role to further improve the mechanical strength of the heat-radiating sheet, and moreover, when the heat-radiating sheet is compressed in the thickness direction, there is also brought an effect for suppressing elongation of the heat-radiating sheet to the planar direction, thereby securing the insulation. Examples of the reinforcing layer include a glass cloth; a resin film made of polyester, polyamide, polyimide, polycarbonate, acrylic resin, etc.; a cloth fiber mesh cloth made of cotton, hemp, aramid fiber, cellulose fiber, nylon fiber, polyolefin fiber, etc.; a nonwoven fabric made of aramid fiber, cellulose fiber, nylon fiber, polyolefin fiber, etc.; a metal fiber mesh cloth made of stainless steel, copper, aluminum, etc.; and a metal foil made of copper, nickel, aluminum, etc. These can be used either alone or in combination of two or more thereof. Of these, a glass cloth is preferred from the viewpoint of thermal conductivity and insulation.

In the case of using a glass cloth as the reinforcing layer, a generally marketed glass cloth having openings can be used. A thickness of the glass cloth is preferably 10 pm to 150 pm. In the case where the thickness of the glass cloth is 10 pm or more, the glass cloth can be suppressed from breakage at the time of handling. On the other hand, in the case where the thickness of the glass cloth is 150 pm or less, a lowering of the thermal conductivity of the heat-radiating sheet owing to the glass cloth can be suppressed. From such viewpoint, the thickness of the glass cloth is more preferably 20 to 90 pm, and still more preferably 30 to 60 pm. Among marketed glass cloths, there are ones having a fiber diameter of 4 to 9 pm, and these can be used for the heat-radiating sheet. In addition, a tensile strength of the glass cloth is, for example, 100 to 1,000 N/25 mm. In addition, a length of one side of the opening of the glass cloth is preferably 0.1 to 1.0 mm from the viewpoint of balancing between the thermal conductivity and the strength. Examples of the glass cloth which can be used for the heat-radiating sheet include a trade name "H25 F104", manufactured by Unitika Ltd.

The heat-radiating sheet may contain other component than the resin binder, the filler, and the reinforcing layer. Examples of the other component include additives and impurities. The content of the other component in 100% by volume of the volume of the heat-radiating sheet is, for example, 5% by volume or less, preferably 3% by volume or less, and more preferably 1% by volume or less.

Examples of the additives include a reinforcing agent, an extending agent, a heat resistance-improving agent, a flame retarder, an adhesive aid, a conducting agent, a surface treatment agent, and a pigment.

### <Base Material Resin Layer>

The heat-radiating sheet of the present invention may be provided with a base material resin layer. The base material resin layer takes a role to further improve the heat resistance and insulation of the heat-radiating sheet. In this case, the heat-radiating sheet of the present invention includes a resin composition layer containing the aforementioned resin binder and inorganic filler and a base material resin layer adjacent to this resin composition layer. The resin composition layer may be provided with the aforementioned reinforcing layer.

The base material resin layer preferably contains a resin having a glass transition point of 200°C or higher. When the glass transition point is 200°C or higher, sufficient heat resistance is obtained, and the insulation or thermal conductivity of the laminate can be maintained favorable. The base material resin layer may be a layer formed of a coating film or may be formed of a film.

Examples of the resin constituting the base material resin layer include a polyimide, a polyamide-imide, a polyamide (in particular, an aromatic polyamide), a polyether sulfone, a polyether imide, polyethylene naphthalate, polytetrafluoroethylene (PTFE), and a tetrafluoroethylene/perfluoroalkyl vinyl ether copolymer (PFA). Above all, a polyimide is preferred. In addition, these resins can be used either alone or in combination of several kinds thereof.

Although the content of the resin in the base material resin layer is not particularly limited, a lower limit thereof is preferably 78% by volume or more, more preferably 80% by volume or more, and still more preferably 82% by volume or more. An upper limit thereof is preferably 92% by volume or less, more preferably 90% by volume or less, and still more preferably 88% by volume or less.

It is preferred that the base material resin layer contains an inorganic filler. When the base material resin layer contains an inorganic filler, the insulation, thermal conductivity, peel strength, and so on can be improved. In particular, it may be assumed that the rise of the peel strength resides in the matter that unevennesses are formed at an interface between the base material resin layer and the resin composition layer owing to the inorganic filler, whereby an anchor effect is produced. As the inorganic filler, the same materials as those in the aforementioned inorganic filler can be used.

Although the content of the inorganic filler in the base material resin layer is not particularly limited, a lower limit thereof is preferably 8% by volume or more, more preferably 10% by volume or more, and still more preferably 12% by volume or more. An upper limit thereof is preferably 22% by volume or less, more preferably 20% by volume or less, and still more preferably 18% by volume or less.

In the base material resin layer, the aforementioned additives may be contained in small amounts, and the impurities may be contained in small amounts. In the base material resin layer, the total content of the aforementioned resin and inorganic filler is preferably 90% by volume or more, more preferably 95% by volume or more, and still more preferably 97% by volume or more.

From the viewpoint of insulation, thermal conductivity, and processability, the thickness of the base material resin layer is preferably the following range. A lower limit thereof is preferably 0.010 mm or more. By setting the thickness of the base material resin layer to 0.010 mm or more, not only the insulation can be further improved, but also the processability can be improved. The thickness of the base material resin layer is more preferably 0.012 mm or more, and still more preferably 0.015 mm or more. An upper limit thereof is preferably 0.100 mm or less, more preferably 0.070 mm or less, and still more preferably 0.050 mm or less.

The film serving as the base material resin layer can be fabricated in conformity with a known film fabricating method. In addition, products which are on sale in the market may be acquired and used.

### (Form of Heat-Radiating Sheet)

In the present invention, the form of the heat-radiating sheet is not particularly limited. The heat-radiating sheet of the present invention may be any of a sheet product and a roll product.

### (Production Method of Heat-Radiating Sheet)

In the case of using a silicone resin as the resin binder, using a massive boron nitride particle as the filler, and using a glass cloth as the reinforcing layer, the heat-radiating sheet of the present invention can be, for example, produced by a production method including the following step 1 to step 4.

### (Step 1)

In the step 1, the silicone resin before curing and the massive boron nitride particle are mixed to fabricate a composition for heat-radiating sheet.

### (Step 2)

In the step 2, after placing a glass cloth on a film having releasability, the composition for heat-radiating sheet is applied on the film having releasability from the top of the glass cloth and then dried at 60 to 80°C for 4 to 7 minutes, to mold into a sheet form. The application method is not particularly limited, and a known application method capable of performing uniform application, such as a doctor blade method, a comma coater method, a screen printing method, and a roll coater method, can be adopted. But, from the viewpoint that the thickness of the applied composition for heat-radiating sheet can be controlled with high accuracy, a doctor blade method and a comma coater method are preferred. In addition, the film having releasability is, for example, a PET film. The composition for heat-radiating sheet may be applied on one of the surfaces of the glass cloth, or the composition for heat-radiating sheet may be applied on the both surfaces of the glass cloth. In the case of applying the composition for heat-radiating sheet on the both surfaces of the glass cloth, after applying the composition for heat-radiating sheet on one of the surfaces of the glass cloth, the composition for heat-radiating sheet may be applied on the other surface of the glass cloth. In addition, the composition for heat-radiating sheet may be simultaneously applied on the both surfaces of the glass cloth.

In the case of the heat-radiating sheet provided with the base material resin layer, the resin composition is applied on a base material sheet serving as the base material resin layer. As the application method on the base material sheet, a conventionally known method, for example, a coater method, a doctor blade method, an extrusion molding method, an injection molding method, and a press molding method, can be adopted. Even in the case of the heat-radiating sheet provided with the base material resin layer, the composition for heat-radiating sheet may be applied on the both surfaces of the base material resin layer such that the base material resin layer is arranged in the center in the thickness direction of the heat-radiating sheet, followed by drying.

### (Step 3)

In the step 3, by heating and pressurizing the composition for heat-radiating sheet, which has been applied on the film having releasability, in an air atmosphere by using a heat pressing machine under conditions at a pressure of 100 to 200 kgf/cm² and at a heating temperature of 50 to 80°C for a pressurizing time of 30 to 40 minutes, the composition for heat-radiating sheet is subjected to temporary molding. According to this, the coagulation of massive boron nitride particles can be appropriately loosened. By setting the heating temperature to 50°C or higher, occurrence of the matter that coagulation of the massive boron nitride particles excessively collapse, and the flaky particles of born nitride are oriented, whereby the thermal conductivity of the heat-radiating sheet is lowered can be suppressed. In addition, by setting the heating temperature to 80°C or lower, the air bubbles in the composition for heat-radiating sheet are removed to increase the density of the heat-radiating sheet, whereby the insulation of the heat-radiating sheet can be improved.

### (Step 4)

In the step 4, by further heating and pressurizing the composition for heat-radiating sheet, which has been subjected to temporary molding, in an air atmosphere, a nitrogen atmosphere, an argon atmosphere, or a hydrogen atmosphere, or under vacuum by using a heat pressing machine under conditions at a pressure of 100 to 200 kgf/cm² and at a heating temperature of 80 to 170°C for a pressurizing time of 10 to 60 minutes, the composition for heat-radiating sheet is subjected to actual molding. By setting the pressure to 100 kgf/cm² or more, the heating temperature to 80°C or higher, and the pressurizing time to 10 minutes or more, respectively, bondability between the composition for heat-radiating sheet and the glass cloth can be improved. In addition, by setting the pressure to 200 kgf/cm² or less, the heating temperature to 170°C or lower, and the pressurizing time to 60 minutes or less, respectively, not only the productivity of the heat-radiating sheet can be improved, but also the production costs can be reduced. In addition, as mentioned above, in the present invention, since the quantity of voids is reduced by gradually performing the heating and pressurization, the pressurizing force in this step is larger than the pressurizing force in the step 3.

The heat-radiating sheet of the present invention may be produced by a production method further including the following step 5 after the aforementioned step 4.

### (Step 5)

In the step 5, the composition for heat-radiating sheet which has been subjected to actual molding is heated under conditions at a heating temperature of 130 to 250°C for a heating time of 2 to 30 hours, thereby further curing the composition for heat-radiating sheet. According to this, the low-molecular weight siloxane in the resin can be removed. When the concentration of the low-molecular weight siloxane in the resin is high, there is a case where a siloxane gas is emitted, an insulating coating film made of silicon oxide is produced on an electrical contact owing to energy, such as sliding and a spark of the electrical contact, thereby causing a contact fault.

### Examples

The present invention is hereunder described in detail by reference to Examples and Comparative Examples. It should be construed that the present invention is not limited to the following Examples.

The heat-radiating sheets of the Examples and Comparative Examples were subjected to the following evaluations.

### (Thickness of Heat-Radiating Sheet)

The thickness of the heat-radiating sheet was measured with a micrometer with respect to five optional places, and an average value thereof was expressed as the thickness of the heat-radiating sheet of each of the Examples and Comparative Examples.

### (Volume Resistivity of Heat-Radiating Sheet)

Three heat-radiating sheets impregnated with an antifreeze containing 98% by mass or more of ethylene glycol (Antifreeze Super, manufactured by General Sekiyu K.K.) at a temperature of 25°C for 250 hours were prepared. Then, the volume resistivity of the heat-radiating sheet was measured at an impression voltage of DC 500V according to JIS K6911.

Heat-radiating sheets impregnated with the aforementioned antifreeze for 500 hours and 1,000 hours, respectively, a heat-radiating sheet impregnated with gasoline (regular gasoline, manufactured by General Sekiyu K.K.) at a temperature of 25°C for 1,000 hours, and a heat-radiating sheet impregnated with engine oil (G Urban SDCC (viscosity: 20W30), manufactured by General Sekiyu K.K.) at a temperature of 25°C for 1,000 hours were also subjected to the same evaluations.

### (Withstanding Voltage of Heat-Radiating Sheet)

As shown in Fig. 1, a heat-radiating sheet 1 was arranged between TO-3P type transistors 2 (Model No.: 2SC3152, manufactured by Mitsubishi Electric Corporation) and an aluminum plate 3. Then, the heat-radiating sheet 1 was tightened at a tightening torque of 12 kgf·cm by using a screw 4 having a nominal diameter of M3mm. A contact area between of the single TO-3P type transistor 2 and the heat-radiating sheet 1 was about 2.8 cm². Thereafter, as shown in Fig. 1(c), an alternating current voltage having a frequency of 60 Hz was impressed between an emitter of the TO-3P type transistor 2 and an aluminum plate 7 by using a withstanding voltage tester 5 (Model No: TOS 5101, manufactured by Kikusui Electronics Corporation), and the voltage was raised from 0 V at a rate of 500 V/s. Then, a voltage at which dielectric breakdown occurred was expressed as the withstanding voltage of the heat-radiating sheet. When a leak electric current between the emitter of the TO-3P type transistor 2 and the aluminum plate 3 exceeded 10 mA, it was judged that the dielectric breakdown occurred. Then, an average value of the withstanding voltage of the three heat-radiating sheets was expressed as the withstanding voltage of the heat-radiating sheet in each of the Examples or Comparative Examples.

The heat-radiating sheets of the Examples and Comparative Examples were fabricated in the following manner.

### [Example 1]

### (Fabrication of Hexagonal Boron Nitride)

Boric acid, melamine, and calcium carbonate (all being a special grade reagent) were mixed in a proportion of 70/50/5 in terms of a mass ratio; the temperature was raised in a nitrogen gas atmosphere from room temperature to 1,400°C over 1 hour; after retaining at 1,400°C for 3 hours, the temperature was raised to 1,900°C over 4 hours; and after retaining at 1,900°C for 2 hours, cooling to room temperature was performed to produce hexagonal boron nitride. After crushing this, the resultant was pulverized and sieved to fabricate a massive boron nitride particle. An average particle diameter of the fabricated massive boron nitride particle was 20 pm.

### (Fabrication of Composition for Heat-Radiating Sheet)

22 g of a silicone resin (Model No.: LR3303-20A, manufactured by Wacker Asahikasei Silicone Co., Ltd.), 22 g of a silicone resin (Model No.: LR3303-20B, manufactured by Wacker Asahikasei Silicone Co., Ltd.), and 137 g of the fabricated massive boron nitride particle were added; then, toluene was added as a viscosity modifier such that the solid component concentration was 60 wt%; and the contents were mixed with a stirrer (trade name: Three-One Motor, manufactured by HEIDON Inc.) using a turbine type stirring blade for 15 hours, to fabricate a composition for heat-radiating sheet.

### (Fabrication of Heat-Radiating Sheet)

After arranging a glass cloth (trade name: H25 F 104, manufactured by Unitika Ltd.) on a Teflon (registered trademark) sheet, the aforementioned silicone composition was applied in a thickness of 0.2 mm on the glass cloth by using a comma coater, followed by drying at 75°C for 5 minutes. Subsequently, the dried silicone composition was turned over such that the glass cloth was located on the upper side; and the silicone composition was applied in a thickness of 0.2 mm on the glass cloth by using a comma coater, followed by drying at 75°C for 5 minutes, to fabricate a sheet of the silicone composition in which the silicone composition was applied on the both surfaces of the glass cloth. Thereafter, using a flat plate pressing machine (manufactured by Yanase Seisakusho Co., Ltd.), pressing was performed for 35 minutes under conditions at a temperature of 70°C and at a pressure of 120 kgf/cm², thereby performing temporary molding. Thereafter, the temperature was raised to 150°C at a temperature rise rate of 10°C/min while pressing at a pressure of 150 kgf/cm². Then, pressing was performed for 45 minutes under conditions at a temperature of 150°C and at a pressure of 150 kgf/cm², to perform actual molding. Subsequently, the resultant was subjected to secondary heating for 4 hours at atmospheric pressure and at a temperature of 150°C, thereby fabricating a heat-radiating sheet having a thickness of 0.30 mm of Example 1. The content of the inorganic filler was 60% by volume relative to 100% by volume of the total of the resin binder and the inorganic filler in the heat-radiating sheet.

### [Comparative Example 1]

A heat-radiating sheet of Comparative Example 1 was fabricated in the same manner as in Example 1, except that the temporary molding was not performed.

### [Example 2]

The thickness on the occasion of applying the composition for heat-radiating sheet fabricated using the same raw materials as in Example 1 on the glass cloth by using a comma coater was changed from 0.2 mm to 0.15 mm. Subsequently, the dried composition for heat-radiating sheet was turned over such that the glass cloth was located on the upper side, and applied in a thickness of 0.15 mm as changed from 0.2 mm on the glass cloth by using a comma coater. Other than that, the same method as in Example 1 was performed to fabricate a heat-radiating sheet having a thickness of 0.20 mm.

### [Example 3]

Aheat-radiating sheet having a thickness of 0.20 mm was fabricated in the same method as in Example 1, except that the glass cloth (trade name: H25 F104, manufactured by Unitika Ltd.) was changed to a polyimide film (trade name: Kapton 100H, manufactured by "DU PONT-TORAY CO., LTD., thickness: 0.026 mm), and the composition for heat-radiating sheet was applied in a thickness of 0.3 mm on only one surface thereof, followed by drying.

### [Comparative Example 2]

The thickness on the occasion of applying the composition for heat-radiating sheet fabricated using the same raw materials as in Comparative Example 1 on the glass cloth by using a comma coater was changed from 0.2 mm to 0.15 mm. Subsequently, the dried composition for heat-radiating sheet was turned over such that the glass cloth was located on the upper side, and applied in a thickness of 0.15 mm as changed from 0.2 mm on the glass cloth by using a comma coater. Other than that, the same method as in Comparative Example 1 was performed to fabricate a heat-radiating sheet having a thickness of 0.20 mm.

The evaluation results are shown in Table 1.

**Table 1**

| | | | | Example 1 | Comparative Example 1 | Example 2 | Example 3 | Comparative Example 2 |
|---|---|---|---|---|---|---|---|---|
| Thickness | | | mm | 0.30 | 0.30 | 0.20 | 0.20 | 0.20 |
| Withstanding voltage | | | kV | 9.8 | 8.8 | 7.5 | 13 | 5.7 |
| Antifreeze | 0 hr | Volume resistivity | Ω·cm | 5.0 × 10¹⁴ | 1.2 × 10¹⁴ | 2.0 × 10¹⁴ | 3.0 × 10¹⁵ | 3.0 × 10¹⁴ |
| | 250 hr | | | 4.7 × 10⁹ | 7.3 × 10⁷ | 6.5 × 10⁹ | 6.8 × 10¹¹ | 1.3 × 10⁸ |
| | 500 hr | | | 6.3 × 10⁹ | 3.2 × 10⁷ | 4.8 × 10⁹ | 1.3 × 10¹² | 1.3 × 10⁷ |
| | 1000hr | | | 1.1 × 10⁹ | 1.0 × 10⁷ | 5.4 × 10⁹ | 8.3 × 10¹¹ | 9.5 × 10⁶ |
| Gasoline | 1000 hr | | | 3.0 × 10¹⁴ | 2.1 × 10⁷ | 2.1 × 10¹⁴ | 3.3 × 10¹⁵ | 1.3 × 10⁷ |
| Engine oil | 1000 hr | | | 2.0 × 10¹⁴ | 3.2 × 10⁷ | 3.2 × 10¹⁴ | 4.5 × 10¹⁵ | 8.8 × 10⁶ |

From the foregoing evaluation results, it was noted that the heat-radiating sheet, in which in the case of impregnating with the antifreeze containing 98% by mass or more of ethylene glycol at a temperature 25°C for 250 hours, the volume resistivity as measured by a direct current voltage of 500 V according to JIS K6911 after being impregnated with the antifreeze is 1.0 × 10⁹ Ω·cm or more, has high tolerance against gasoline and engine oil. In addition, it was noted that by examining a rate of reduction of thermal resistivity of the heat-radiating sheet when impregnated with the antifreeze for 250 hours, it is able to evaluate the heat-radiating sheets impregnated with gasoline and engine oil, respectively for 1,000 hours.

From the results of the volume resistivity of each of the heat-radiating sheets in which the impregnation time of the heat-radiating sheet with the antifreeze is 250 hours, 500 hours, and 1,000 hours, respectively, it could be confirmed that the volume resistivity of the heat-radiating sheets, the impregnation time of which is 500 hours and 1,000 hours, respectively, can be evaluated by one at the impregnation time of 250 hours.

The dielectric breakdown voltage of Example 1 and Example 3 was evaluated by a short-time breakdown test (at room temperature: 23°C) in conformity with JIS C2110. As a result, in Examples 3, the dielectric breakdown voltage was higher by about 3 kV.

### Reference Signs List

1: Heat-radiating sheet
2: TO-3P type transistor
3: Aluminum plate
4: Screw
5: Withstanding voltage tester

## Claims

1. Aheat-radiating sheet (1) having a volume resistivity of 1.0 × 10⁹ Ω·cm or more, the volume resistivity being measured by a method comprising impregnating the heat-radiating sheet with an antifreeze containing 98% by mass or more of ethylene glycol at a temperature 25°C for 250 hours and subsequently applying a direct current voltage of 500 V according to JIS K6911-1995.

2. The heat-radiating sheet according to claim 1, wherein a withstanding voltage of the heat-radiating sheet is 6.0 kV or more, the withstanding voltage being measured by allowing the heat-radiating sheet to intervene between a TO-3P type transistor (2) and an aluminum (3), fixing the TO-3P type transistor to the aluminum plate at a tightening torque of 12 kgf·cm by using a screw (4), and impressing an alternating current voltage having a frequency of 60 Hz between a drain of the TO-3P type transistor and the aluminum plate.

3. The heat-radiating sheet according to claim 1 or 2, comprising a resin binder and an inorganic filler.

4. The heat-radiating sheet according to claim 3, wherein the resin binder is a silicone resin.

5. The heat-radiating sheet according to claim 3 or 4, wherein the inorganic filler is a coagulated particle of hexagonal boron nitride.

6. The heat-radiating sheet according to any one of claims 3 to 5, comprising a glass cloth.

7. The heat-radiating sheet according to any one of claims 1 to 6, comprising a base material resin layer including a resin having a glass transition point of 200°C or higher.

## Patentansprüche

1. Wärmeabstrahlende Folie (1) mit einem spezifischen Volumenwiderstand von 1,0 · 10⁹ Ω·cm oder mehr, wobei der spezifische Volumenwiderstand mit einem Verfahren gemessen wird, das ein Imprägnieren der wärmeabstrahlenden Folie mit einem Frostschutzmittel, das 98 Masse-% oder mehr an Ethylenglykol enthält, bei einer Temperatur von 25 °C über 250 Stunden und anschließendes Anlegen einer Gleichspannung von 500 V gemäß JIS K 6911-1995 umfasst.

2. Wärmeabstrahlende Folie nach Anspruch 1, wobei eine Spannungsfestigkeit der wärmeabstrahlenden Folie 6,0 kV oder mehr beträgt, wobei die Spannungsfestigkeit durch Anordnen der wärmeabstrahlenden Folie zwischen einem Transistor vom Typ TO-3P (2) und einer Aluminiumplatte (3), Befestigen des Transistors vom Typ TO-3P an der Aluminiumplatte mit einem Anzugsdrehmoment von 12 kgf·cm unter Verwendung einer Schraube (4) und Anlegen einer Wechselspannung mit einer Frequenz von 60 Hz zwischen einem Drain des Transistors vom Typ TO-3P und der Aluminiumplatte gemessen wird.

3. Wärmeabstrahlende Folie nach Anspruch 1 oder 2, umfassend ein Harz-Bindemittel und einen anorganischen Füllstoff.

4. Wärmeabstrahlende Folie nach Anspruch 3, wobei das Harz-Bindemittel ein Siliconharz ist.

5. Wärmeabstrahlende Folie nach Anspruch 3 oder 4, wobei der anorganische Füllstoff ein koaguliertes Partikel aus hexagonalem Bornitrid ist.

6. Wärmeabstrahlende Folie nach einem der Ansprüche 3 bis 5, umfassend ein Glasgewebe.

7. Wärmeabstrahlende Folie nach einem der Ansprüche 1 bis 6, umfassend eine Basismaterial-Harzschicht, die ein Harz mit einem Glasübergangspunkt von 200 °C oder höher umfasst.

## Revendications

1. Feuille thermo-rayonnante (1) ayant une résistivité volumique de 1,0 × 10⁹ Ω·cm ou plus, la résistivité volumique étant mesurée par un procédé comprenant l'imprégnation de la feuille thermo-rayonnante avec un antigel contenant 98 % en masse ou plus d'éthylène glycol à une température de 25 °C pendant 250 heures et ensuite l'application d'une tension de courant continu de 500 V conformément à la norme JIS K6911-1995.

2. Feuille thermo-rayonnante selon la revendication 1, dans laquelle une tension de résistance de la feuille thermo-rayonnante est de 6,0 kV ou plus, la tension de résistance étant mesurée en laissant la feuille thermo-rayonnante s'interposer entre un transistor de type TO-3P (2) et une plaque d'aluminium (3), en fixant le transistor de type TO-3P à la plaque d'aluminium à un couple de serrage de 12 kgf-cm à l'aide d'une vis (4), et en appliquant une tension de courant alternatif d'une fréquence de 60 Hz entre un drain du transistor de type TO-3P et la plaque d'aluminium.

3. Feuille thermo-rayonnante selon la revendication 1 ou 2, comprenant un liant résineux et une charge inorganique.

4. Feuille thermo-rayonnante selon la revendication 3, dans laquelle le liant résineux est une résine de silicone.

5. Feuille thermo-rayonnante selon la revendication 3 ou 4, dans laquelle la charge inorganique est une particule coagulée de nitrure de bore hexagonal.

6. Feuille thermo-rayonnante selon l'une quelconque des revendications 3 à 5, comprenant un tissu de verre.

7. Feuille thermo-rayonnante selon l'une quelconque des revendications 1 à 6, comprenant une couche de résine de matériau de base incluant une résine ayant un point de transition vitreuse de 200 °C ou plus.
